# EUROPEAN PATENT APPLICATION

(11) **EP 4 611 505 A1**
(43) Date of publication of application: **03.09.2025**
(21) Application number: 25158164.1
(22) Date of filing: 17.02.2025
(51) Int. Cl.: H10D 30/47, H10D 64/23, H10D 64/27, H10D 30/01, H10D 62/85

(54) **ELECTRONIC DEVICE**

(30) Priority: 29.02.2024 FR 2402000
(71) Applicant: STMicroelectronics International N.V., 1228 Plan-les-Ouates, Geneva (CH)
(72) Inventor: OHEIX, Thomas, 38100 GRENOBLE (FR); CONSTANT, Aurore, 37100 TOURS (FR)
(74) Representative: Cabinet Beaumont

(57) **Abstract**

The present disclosure relates to a device comprising a transistor (10, 40), the transistor comprising:
- a p-doped semiconductor first layer (15);
- a piezoelectric semiconductor second layer (16), covering the first layer (15);
- a piezoelectric semiconductor third layer (18), covering the second layer (16);
- a piezoelectric semiconductor fourth layer (20), covering the third layer (18);
- a piezoelectric semiconductor fifth layer (22), covering the fourth layer (20), the transistor being configured to generate a first two-dimensional electron gas (36) between the fourth and fifth layers (20, 22); and
- a gate pattern (24) crossing going through the fifth (22) layer and at least part of the fourth layer (20).

## Description

### Technical field

The present disclosure relates generally to electronic devices and more especially electronic devices comprising semiconductor-based power transistors.

### Background art

In the field of power electronics, a significant challenge relates to the development of "large band gap" semiconductor-based power transistors, such as GaN.

Different architectures have been specifically developed for these GaN-based transistors. The architectures based on the use of a two-dimensional electron gas (2 DEG), typically making it possible to operate with high source-drain biasing voltages. A positive threshold voltage advantageously makes it possible to simplify the control circuit of the transistor and to ensure the safety of the conversion system in the event of a failure.

### Summary of Invention

One embodiment provides a device comprising a transistor, the transistor comprising: - a p-doped semiconductor first layer; - a piezoelectric semiconductor second layer, covering the first layer; - a piezoelectric semiconductor third layer, covering the second layer; - a piezoelectric semiconductor fourth layer, covering the third layer; - a piezoelectric semiconductor fifth layer, covering the fourth layer, the transistor being configured to generate a first two-dimensional electron gas between the fourth and fifth layers; and - a gate pattern crossing going through the fifth layer and at least part of the fourth layer.

According to an embodiment, the transistor is configured to generate a second two-dimensional electron gas between the second and third layers, the first layer being configured to suppress the second electron gas.

According to an embodiment, the gate pattern crosses the third, fourth and fifth layers and at least part of the second layer.

According to an embodiment, the second and fourth layers are made of the same material.

According to an embodiment, the second and fourth layers are made of GaN.

According to an embodiment, the third and fifth layers are made of the same material.

According to an embodiment, the third and fifth layers are made of AlGaN, AsGa, AlN or InGaN.

According to an embodiment, the first layer is made of GaN doped with magnesium, carbon or iron.

According to an embodiment, the first layer is configured not to be biased.

According to an embodiment, the gate pattern separates at least the fifth layer in a first part and a second part.

According to an embodiment, the gate pattern separates the third, fourth and fifth layers in a first part and a second part.

According to an embodiment, the device comprises a first electrode in contact with the first part of fifth layer and a second electrode in contact with the second part of fifth layer.

According to an embodiment, the first layer is configured to be biased with the same voltage as either the first or second electrode.

### Brief description of drawings

The foregoing features and advantages, as well as others, will be described in detail in the following description of specific embodiments given by way of illustration and not limitation with reference to the accompanying drawings, in which:
Figure 1 illustrates an example of an electronic device comprising a semiconductor-based power transistor;
Figure 2 illustrates an embodiment of an electronic device comprising a semiconductor-based power transistor;
Figure 3 illustrates the behavior of the electronic device of Figure 2; and
Figure 4 illustrates another embodiment of an electronic device comprising a semiconductor-based power transistor.

### Description of embodiments

Like features have been designated by like references in the various figures. In particular, the structural and/or functional features that are common among the various embodiments may have the same references and may dispose identical structural, dimensional and material properties.

For the sake of clarity, only the operations and elements that are useful for an understanding of the embodiments described herein have been illustrated and described in detail.

Unless indicated otherwise, when reference is made to two elements connected together, this signifies a direct connection without any intermediate elements other than conductors, and when reference is made to two elements coupled together, this signifies that these two elements can be connected or they can be coupled via one or more other elements.

In the following disclosure, unless indicated otherwise, when reference is made to absolute positional qualifiers, such as the terms "front", "back", "top", "bottom", "left", "right", etc., or to relative positional qualifiers, such as the terms "above", "below", "higher", "lower", etc., or to qualifiers of orientation, such as "horizontal", "vertical", etc., reference is made to the orientation shown in the figures.

Unless specified otherwise, the expressions "around", "approximately", "substantially" and "in the order of" signify within 10 %, and preferably within 5 %.

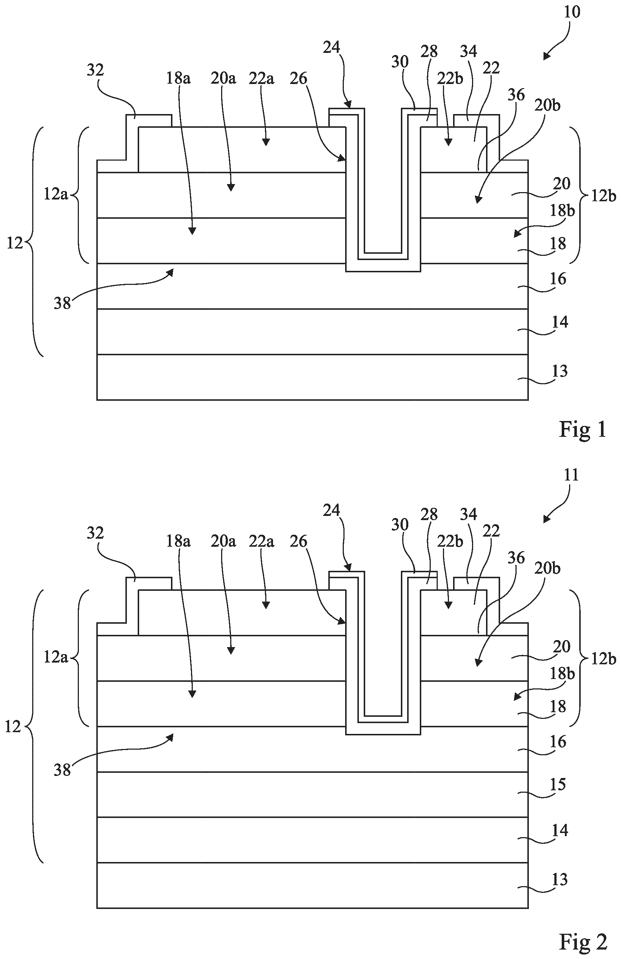

Figure 1 illustrates an example of an electronic device comprising a semiconductor-based power transistor.

More precisely, Figure 1 illustrates schematically a part of a device comprising the power transistor 10. The transistor 10 is a High Electron Mobility Transistor (HEMT)-type transistor. Such a transistor is a field effect transistor with high electron mobility, also sometimes referenced by the term of heterostructure field effect transistor.

The transistor 10 comprises a stack 12 of layers 14, 16, 18, 20, 22. The stack 12 is for example located in or on a semiconductor substrate 13. The substrate 13 is for example made of silicon, sapphire or SiC. In the example of Figure 1, the stack 12 is located on the upper face of the substrate 13.

The layer 14 is a buffer layer. The layer 14 can correspond to several buffer layers. The buffer layer 14 is for example in AlN, GaN or AlGaN.

The layer 16 is in a piezoelectric material, for example in GaN. The layer 16 is for example intrinsic or unintentionally doped. In other words, layer 16 is either not doped or doped with a doping concentration below 10¹⁴ cm⁻³. Layer 16 is located on, and for example in contact with, layer 14. The layer 16 is for example floating. In other words, layer 16 is for example not biased. Alternatively, layer 16 is biased by the reference voltage, for example the ground.

The layer 18, which constitutes a back barrier, is in a piezoelectric material, for example in AlGaN. The proportion of aluminum is for example higher than 4 %. Layer 18 is located on, and for example in contact with, layer 16. The layer 18 is for example floating.

The layer 20, which constitutes a channel, is in a piezoelectric material, for example in GaN. Layer 20 is located on, and for example in contact with, layer 18.

The layer 22, which constitutes a barrier, is in a piezoelectric material, for example in AlGaN. The proportion of aluminum is for example higher than 4 %. Layer 22 is located on, and for example in contact with, layer 20. Layer 22 for example does not cover entirely layer 20. In other words, a part of layer 20, for example a part of the upper face of layer 20, is not covered by the layer 22.

The transistor 10 comprises a gate pattern 24. The gate pattern 24 is located in a cavity 26. The cavity extends from the upper face of layer 22, through layer 22 and part of layer 20. In other words, the cavity 26 extends through the interface between layers 20 and 22. The cavity 26 extends through layers 18, 20, 22 and through part of layer 16. In other words, the bottom of the cavity 26 of Figure 1 is located in the layer 16.

The layers crossed by the cavity, for example the layers 18, 20, 22 in Figure 1, are divided in two parts by the cavity 26. Layer 18 is divided in parts 18a and 18b, parts 18a and 18b not being in contact with each other. Layer 20 is divided in parts 20a and 20b, parts 20a and 20b not being in contact with each other. Layer 22 is divided in parts 22a and 22b, parts 22a and 22b not being in contact with each other. Parts 18a, 20a, 22a form a secondary stack 12a and parts 18b, 20b and 22b form a secondary stack 12b. The secondary stacks 12a and 12b are separated by the cavity 26.

The layer 16 is a continuous layer. In other words, the layer 16 is made of a single part. The portion of layer 16 facing parts 18a, 20a, 22a, for example in contact with part 18a, and the portion of layer 16 facing parts 18b, 20b, 22b, for example in contact with part 18b, are in contact with each other. Said portions of layer 16 are, therefore, not separated by a layer in a different material.

The gate pattern 24 comprises a dielectric layer 28 and a conductive layer 30. Layer 28 covers conformaly the cavity 28 and part of the upper face of the layer 22 surrounding the cavity 26. In other words, layer 28 covers the lateral face of the layers 16, 18, 20, 22 forming the walls of the cavity, the face of the layer 16 forming the bottom of the cavity 26 and part of the upper face of the layer 22 surrounding the cavity 26. Layer 30 covers conformaly layer 28. Preferably, layer 30 covers entirely, and only, layer 28. Layer 30 is therefore separated from stack 12 by layer 28.

The transistor 10 comprises a drain electrode 32 and a source electrode 34. The drain electrode 32 is in contact with both layers 20 and 22 on one side of the cavity 26 and the source electrode 34 is in contact with both layers 20 and 22 on the other side of the cavity 26. More precisely, the drain electrode 32 is in contact with parts 20a and 22a of the layers 20 and 22 and the source electrode 34 is in contact with parts 20b and 22b of the layers 20 and 22. In the example of Figure 1, the drain electrode 32 covers part of the upper face of part 22a, part of the upper face of part 20a which is not covered by part 22a, and the lateral face of part 22a. Similarly, the source electrode 34 covers part of the upper face of part 22b, part of the upper face of part 20b which is not covered by part 22b, and the lateral face of part 22b.

The architecture of a HEMT transistor such as transistor 10 includes the superposition of two semiconductive layers having different band gaps which form a quantum well at their interface. This quantum well is induced by the present spontaneous and piezoelectric biasing charges. Electrons are confined in this quantum well to form a two-dimensional electron gas (2DEG). In the stack 12 of Figure 1, a two-dimensional electron gas 36 is formed under the layer 22, in the layer 20. The two-dimensional electron gas 36 is typically confined at the interface between the layers 20 and 22. Layers 20 and 22 form an heterojunction.

The gate pattern 24 passes through this interface between layers 20 and 22, so as to interrupt the two-dimensional electron gas 36. Controlling the gate voltage Vgs makes it possible to enable or block the passage of electrons of the two-dimensional electron gas 36 on either side of the gate pattern 24.

Generally, if the gate of the transistor is set to a voltage greater than a threshold voltage, there is an accumulation of electrons under the gate dielectric, thus connecting the two-dimensional electron gas on either side of it, which makes it possible to connect the source and the drain such that the transistor enters an on state. Therefore, when the gate pattern 24 is in a state to enable the passage of electrons, the two-dimensional electron gas 36 extends between the parts 20a and 22a, along the walls and the bottom of the cavity 26 and between the parts 20b and 22b.

If the gate of the transistor is set at a voltage less than the threshold voltage, the source and the drain are no longer connected and the transistor enters an off state.

A second two-dimensional electron gas 38 is formed under the layer 18, in the layer 16. The two-dimensional electron gas 38 is typically confined at the interface between layers 16 and 18. The two-dimensional electron gas 38 generates an unwanted constant leakage current flowing between the drain and the source of transistor 10.

Figure 2 illustrates an embodiment of an electronic device comprising a semiconductor-based power transistor 11. More precisely, Figure 2 illustrates schematically a part of a device comprising the power transistor 11. The transistor 11 is a High Electron Mobility Transistor (HEMT)-type transistor. Such a transistor is a field effect transistor with high electron mobility, also sometimes referenced by the term of heterostructure field effect transistor.

The device is for example intended for the automotive industry. The electrification of automotive vehicles generates an expanding high level of electronic content in vehicles. The device for example comprises High Electron Mobility Transistor (HEMT) to be incorporated in said vehicles. The automatization of driving also generates an expanding high level of electronic content in vehicles.

The device can for example be used in the industrial field. More especially, the device for example aims at being used for the development of green energies or for the electrification of infrastructures, for example for charging stations or for the incorporation of solar energy. The device can also be used in the field of the internet of things and of smart homes. The device is for example intended for being implemented in the power and energy circuits of pieces of equipment, comprising for example 650V or 1200V HEMT, 1200V ultrafast and silicon carbide diodes, transient-voltage-suppression diodes, and protections against electromagnetic discharges. The device can also be used in the implementation of clouds, 5G networks, data centers and servers. The device for example comprises wide band gap materials.

The device is for example intended for being used in personal electronics, for example in the aim of increasing radio frequency content, in device of 5G connections or more generally in connected devices. The device is for example a smartphone or a part of a network of internet of things. The device is for example connected by 5G, WIFI or ultra-wide band. The device for example includes high speed interfaces, for example with advanced filtering and protection against electromagnetic discharges.

The device is for example intended for being used in communication equipment, or in computers and peripherals. For example, the device can be used in 5G infrastructure and dedicated data centers. The device comprises for example silicon carbide diodes, power Schottky transistors, protections against electromagnetic discharges and transient-voltage-suppression diodes. The device can also be used in satellites, comprising for example integrated passive devices for radio frequency applications.

The disclosed device comprises a HEMT-type transistor. HEMT-type transistors are typically used in high-frequency and high-power applications such as satellite communications, radar systems, battery chargers, computers, servers, automotive, lightning systems and photovoltaic systems, microwave amplifiers, and all equipment requiring power conversion, for example DC/DC or AC/DC or AC/AC or DC/AC power conversion. HEMT-type transistors may also be used in some specialized personal electronic devices such as high-end audio amplifiers or radio frequency (RF) transmitters. HEMT-type transistors are increasingly being used in car electrification, particularly in electric and hybrid vehicles.

The transistor 11 comprises, like the device 10 of Figure 1, a stack 12 of layers 14, 16, 18, 20, 22. In the embodiment of Figure 2, the stack 12 further comprises a layer 15. Preferably, the layers 14, 15, 16, 18, 20, 22 of the stack 12 are disposed in this order from the substrate. The stack 12 is for example located in or on the semiconductor substrate 13. The substrate is for example made of silicon, sapphire or SiC.

The layer 14 is a buffer layer. The layer 14 can correspond to several buffer layers. The buffer layer 14 is for example in AlGaN, AlN or GaN. Layer 14 is for example the lowest layer of the stack 12. In other words, layer 14 is for example the closest layer to the substrate 13.

The layer 15 is a semiconductor layer. The layer 15 is p-doped. For example, the layer 15 is in GaN. For example, the layer 15 is doped with magnesium, carbon or iron. Layer 15 is for example the second lowest layer of the stack 12. Layer 15 is for example separated, preferably entirely, from the substrate by layer 14. The doping concentration is for example higher than 10¹⁷ cm⁻³, for example substantially equal to 10¹⁸ cm⁻³.

Preferably, the layer 15 is floating. In other words, layer 15 is preferably not biased. Alternatively, layer 15 is biased by the reference voltage, for example the ground.

The layer 16 is in a piezoelectric material, preferably a piezoelectric semiconductor material. Layer 16 constitutes a buried channel or an interlayer. Layer 16 is preferably in a material configured to be formed, for example to be grown by epitaxy, on the layer 15. The layer 16 is for example in GaN. The layer 16 is preferably intrinsic or unintentionally doped. In other words, layer 16 is either not doped or doped with a doping concentration below 10¹⁴ cm⁻³. For example, the layer 16 is in the same material as layer 15.

Layer 16 is for example the third lowest layer of the stack 12. Layer 16 is for example located on, and preferably in contact with, layer 15. Layer 16 is for example separated, preferably entirely, from layer 14 by layer 15.

Preferably, the layer 16 is floating. In other words, layer 16 is preferably not biased. Alternatively, layer 16 is biased by the reference voltage, for example the ground.

The layer 18 is in a piezoelectric material, preferably a piezoelectric semiconductor material. Layer 18 constitutes a back barrier. Layer 18 is preferably in a material configured to be formed, for example to be grown by epitaxy, on the layer 16. The layer 18 is in a material different from the material of layer 16. The layer 18 is for example in AlGaN, in InGaN, in AsGa or in AlN. Preferably, the layer 18 is in AlGaN, the proportion of aluminum being higher than 4 %.

Layer 18 is for example the fourth lowest layer of the stack 12. Layer 18 is for example located on, and preferably in contact with, layer 16. Layer 18 is for example separated, preferably entirely, from layer 15 by layer 16. Layer 18 is preferably not in contact with layer 15.

Preferably, the layer 18 is floating. In other words, layer 18 is preferably not biased. Alternatively, layer 18 is biased by the reference voltage, for example the ground.

The layer 20 is in a piezoelectric material, preferably a piezoelectric semiconductor material. Layer 20 constitutes a channel. Layer 20 is preferably in a material configured to be formed, for example to be grown by epitaxy, on the layer 18. The layer 20 is in a material different from the material of layer 18. For example, the material of layer 20 is the same material as the material of layer 16. Layer 20 is for example in GaN.

Layer 20 is for example the fifth lowest layer of the stack 12. Layer 20 is for example located on, and preferably in contact with, layer 18. Layer 20 is for example separated, preferably entirely, from layer 16 by layer 18. Layer 18 is preferably not in contact with layers 15 and 16.

The layer 22 is in a piezoelectric material, preferably a piezoelectric semiconductor material. Layer 22 constitutes a barrier. Layer 22 is preferably in a material configured to be formed, for example to be grown by epitaxy, on the layer 20. The layer 22 is in a material different from the material of layer 20. Layer 22 is for example in the same material as layer 18. The layer 22 is for example in AlGaN, in InGaN, in AsGa or in AlN. Preferably, the layer 22 is in AlGaN, the proportion of aluminum being higher than 4 %.

Layer 22 is for example the highest layer of the stack 12, in other words, the layer the farthest from the substrate and the farthest from the buffer layer not represented. Layer 22 is for example located on, and preferably in contact with, layer 20. Layer 22 is for example separated, preferably entirely, from layer 18 by layer 20. Layer 22 is preferably not in contact with layers 14, 15, 16, 18. Layer 22 for example does not cover entirely layer 20. In other words, a part of layer 20, for example a part of the upper face of layer 20 is not covered by the layer 22.

According to an embodiment, the layers 16, 18, 20, and 22 are all in different piezoelectric materials. According to another embodiment, layers 16 and 20 are made of the same material and layers 18 and 22 are made of the same material.

Preferably, each of the layers 14, 15, 16, 18, 20, 22 is an homogenous layer. Preferably, each of the layers 14, 15, 16, 18, 20, 22 is made of a single material.

The layer 16 for example has a doping concentration lower that 10¹⁴ cm⁻³. The layer 18 has a thickness between 20 nm and 150 nm. The layer 20 for example has a doping concentration lower that 10¹⁴ cm⁻³. The layer 20 has a thickness for example between 50 nm and 200 nm. The layer 22 has a thickness between 20 nm and 100 nm.

The semiconductive materials of transistor 10 are for example chosen so as to have a wide energy band gap, for power handling (in particular, high voltage) and temperature handling reasons.

The transistor 11 comprises a gate pattern 24. The gate pattern 24 is located in a cavity 26. The cavity extends from the upper face of layer 22. The cavity 26 extends at least through layer 22 and part of layer 20. In other words, the cavity 26 extends through the interface between layers 20 and 22. In the embodiment of Figure 2, the cavity 26 extends through layers 18, 20, 22 and through part of layer 16. In other words, the bottom of the cavity 26 of Figure 2 is located in the layer 16. Preferably, the bottom of the cavity 26 is located between the interface of layers 20 and 22 and the layer 16.

The layers crossed by the cavity, for example the layers 18, 20, 22 in Figure 2, are divided in two parts by the cavity 26. Layer 18 is divided in parts 18a and 18b, parts 18a and 18b not being in contact with each other. Layer 20 is divided in parts 20a and 20b, parts 20a and 20b not being in contact with each other. Layer 22 is divided in parts 22a and 22b, parts 22a and 22b not being in contact with each other. Parts 18a, 20a, 22a form a secondary stack 12a and parts 18b, 20b and 22b form a secondary stack 12b. The secondary stacks 12a and 12b are separated by the cavity 26.

The gate pattern 24 comprises a dielectric layer 28 and a conductive layer 30. Layer 28 covers conformaly the cavity 28 and part of the upper face of the layer 22 surrounding the cavity 26. In other words, layer 28 covers the lateral face of the layers 16, 18, 20, 22 forming the walls of the cavity, the face of the layer 16 forming the bottom of the cavity 26 and part of the upper face of the layer 22 surrounding the cavity 26. Layer 30 covers conformaly layer 28. Preferably, layer 30 covers entirely, and only, layer 28. Layer 30 is therefore separated from stack 12 by layer 28.

The transistor 11 comprises a drain electrode 32 and a source electrode 34. The drain electrode 32 is in contact with both layers 20 and 22 on one side of the cavity 26 and the source electrode 34 is in contact with both layers 20 and 22 on the other side of the cavity 26. More precisely, the drain electrode 32 is in contact with parts 20a and 22a of the layers 20 and 22 and the source electrode 34 is in contact with parts 20b and 22b of the layers 20 and 22. In the example of Figure 2, the drain electrode 32 covers part of the upper face of part 22a, part of the upper face of part 20a which is not covered by part 22a, and the lateral face of part 22a. Similarly, the source electrode 34 covers part of the upper face of part 22b, part of the upper face of part 20b which is not covered by part 22b, and the lateral face of part 22b.

The architecture of a HEMT transistor such as transistor 11 includes the superposition of two semiconductive layers having different band gaps which form a quantum well at their interface. This quantum well is induced by the present spontaneous and piezoelectric biasing charges. Electrons are confined in this quantum well to form a two-dimensional electron gas (2DEG). In the stack 12 of Figure 2, a two-dimensional electron gas 36 is formed under the layer 22, in the layer 20. The two-dimensional electron gas 36 is typically confined at the interface between the layers 20 and 22. Layers 20 and 22 form an heterojunction.

The gate pattern 24 passes through this interface between layers 20 and 22, so as to interrupt the two-dimensional electron gas 36. Controlling the gate voltage Vgs makes it possible to enable or block the passage of electrons of the two-dimensional electron gas 36 on either side of the gate pattern 24.

Generally, if the gate of the transistor is set to a voltage greater than a threshold voltage, there is an accumulation of electrons under the gate dielectric, thus connecting the two-dimensional electron gas on either side of it, which makes it possible to connect the source and the drain such that the transistor enters an on state. Therefore, when the gate pattern 24 is in a state to enable the passage of electrons, the two-dimensional electron gas 36 extends between the parts 20a and 22a, along the walls and the bottom of the cavity 26 and between the parts 20b and 22b.

If the gate of the transistor is set at a voltage less than the threshold voltage, the source and the drain are no longer connected and the transistor enters an off state.

It would be advantageous for the threshold voltage to be positive. Indeed, if the value of the threshold voltage is relatively low (<1V), the device can require a negative Vgs voltage to control the off state. The application of a voltage Vgs<0 involves resorting to a more complex control circuit and the increase of the resistance of the transistor to the on-state.

The layers 16 and 18 allows the increase of the threshold voltage toward higher values.

However, a two-dimensional electron gas 38 is formed under the layer 18, in the layer 16. The two-dimensional electron gas 38 is typically confined at the interface between layers 16 and 18. The two-dimensional electron gas 38 generates a constant leakage current flowing between the drain and the source of transistor 10. This current is all the more important in case where the gate pattern does not cross the interface between the layers 16 and 18.

Layer 15 is made of p-doped semiconductive material. Therefore, layer 15 is configured to deplete electrons in the neighboring regions. In the embodiment of Figure 2, the thickness of layer 16, in other words, the distance between the two-dimensional electron gas 38 and the layer 15, is configured to ensure that the two-dimensional electron gas 38 is at least partially suppressed by the influence of the p-type doping of layer 15. In other words, layer 15 stops the current generated by the two-dimensional electron gas 38. In other words, layer 15 is configured to deplete the two-dimensional electron gas 38.

The choice of the thickness of layer 16 depends on the leakage current generated by the two-dimensional electron gas 38 that needs to be suppressed. In the case of a layer 18 in AlGaN, said leakage current depends on the proportion of aluminum in the layer 18. Preferably, the thickness of layer 16 allowing the compensation of the leakage current decreases as the proportion of aluminum increases. The thickness of layer 16 also depends on the thickness of layer 18.

According to a preferred embodiment, layer 15 is made of GaN doped with magnesium. Preferably, the thickness of layer 15 is higher than 10 nm, preferably higher than 50 nm, for example substantially equal to 100 nm. In the preferred embodiment, layer 15 is floating and does not receive a biasing voltage. According to the preferred embodiment, layer 16 is in intrinsic GaN. Preferably, layer 16 is floating. Preferably, the thickness of layer 16 is lower than 150 nm, preferably lower than 100 nm. According to the preferred embodiment, layer 18 is in AlGaN. Preferably, the proportion of aluminum in layer 18 is higher than 4 %, for example substantially equal to 4 %. Preferably, layer 18 is floating. Preferably, the thickness of layer 18 is higher than 20 nm, for example substantially equal to 75 nm. According to the preferred embodiment, layer 20 is in intrinsic GaN. Preferably, the thickness of layer 20 is higher than 50 nm, for example substantially equal to 80 nm. According to the preferred embodiment, layer 22 is in AlGaN. Preferably, the proportion of aluminum in layer 22 is higher than 4 %, for example substantially equal to 25 %. Preferably, the thickness of layer 22 is comprised between 20 nm and 100 nm, for example substantially equal to 24 nm.

According to another embodiment, the device comprises a contact element configured to bias layer 15. For example, the device comprises an insulated conductive via, not represented, comprising a conductive core and an insulating sheath. The via for example crosses layers 16, 18, 20 to reach the upper face of layer 15.

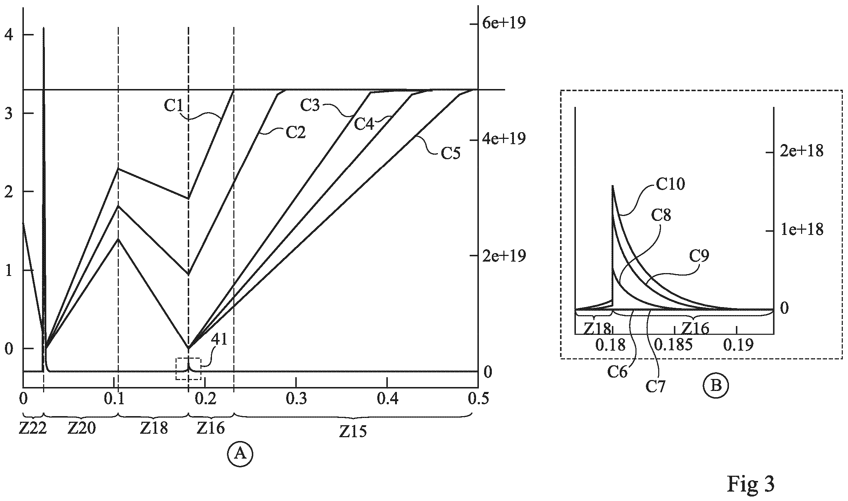

Figure 3 illustrates the behavior of the electronic device of Figure 2. More precisely, Figure 3 illustrates, in view A, with curves C1, C2, C3, C4, C5, the conduction band energy, in the different regions of the transistor 11 of Figure 2 for different values of the thickness of layer 16. Furthermore, Figure 3 illustrates, in view A and in view B with curves C6, C7, C8 C9 and C10, the concentration of electrons, in the different regions of the transistor 11 of Figure 2 for different values of the thickness of layer 16. View B corresponds to a region 41 of view A in larger dimensions.

In the different cases illustrated as examples in Figure 3, layer 15 has a thickness of 100 nm, layer 18 has a thickness of 75 nm, layer 20 has a thickness of 80 nm, and layer 22 has a thickness of 24 nm.

Curves C1 and C6, C6 being identical to C7, correspond to a case where layer 16 has a thickness of 50 nm. Curves C2 and C7 correspond to a case where layer 16 has a thickness of 100 nm. Curves C3 and C8 correspond to a case where layer 16 has a thickness of 150 nm. Curves C4 and C9 correspond to a case where layer 16 has a thickness of 200 nm. Curves C5 and C10 correspond to a case where layer 16 has a thickness of 250 nm.

The curves of Figure 3 comprise different parts corresponding to the different regions of the transistor 11. Part Z22 corresponds to layer 22, part Z20 corresponds to layer 20, part Z18 corresponds to layer 18, part Z16 corresponds to layer 16 and part Z15 corresponds to layer 15.

The transistor is considered to be on. All curves C6 to C10 comprise a peak at the junction between part Z22 and Z20, corresponding to the two-dimensional electron gas 36 between the electrodes of the transistor.

In view B, it is possible to see that curves C8, C9 and C10 comprise a peak at the junction between part Z16 and Z18, corresponding to the two-dimensional electron gas 38 between the electrodes of the transistor. Therefore, the two-dimensional electron gas 38 is not suppressed for the thickness corresponding to curves C8, C9 and C10. It is also possible to see that curves C6 and C7 do not comprise a peak at the junction between part Z16 and Z18. Therefore, for the corresponding thickness of the layer 16, the two-dimensional electron gas 38 is suppressed.

The thicknesses allowing the suppression of the two-dimensional electron gas 38 depend on the composition of the transistor, in particular on the doping values of the different regions and on the thickness of the different regions. It can be determined empirically.

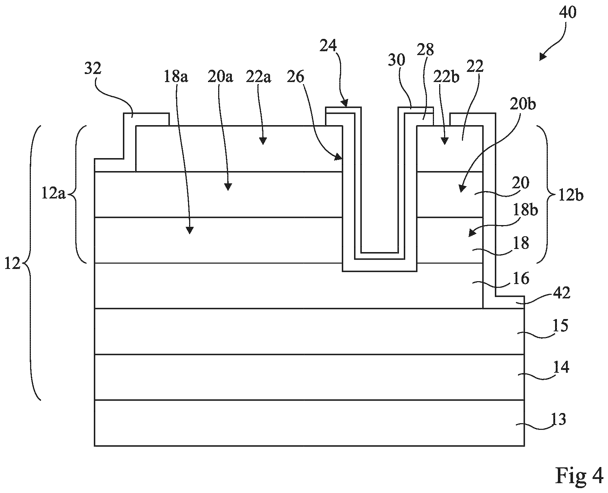

Figure 4 illustrates another embodiment of an electronic device comprising a semiconductor-based power transistor 40.

The power transistor 40 comprises the elements of the transistor 10. Those elements will not be described a second time in detail. In other words, the transistor 40 comprises:
- the buffer layer 14;
- the p-doped layer 15,
- the piezoelectric layer 16,
- the piezoelectric layer 18,
- the piezoelectric layer 20,
- the piezoelectric layer 22,
- the cavity 26,
- the gate pattern 24, comprising the dielectric layer 28 and the conductive layer 30, and
- the drain electrode 32.

The transistor 40 differs from the transistor 11 of Figure 2 in that one of the electrodes, for example the source electrode 34 of Figure 2, is replaced by an electrode 42, which is in contact with the layer 15. For example, a part of the upper face of the layer 14 is not covered by the layers 16, 18, 20, 22. One of the electrodes, for example the electrode 42, covers:
- part of the upper face of layer 22, for example the part 22b,
- the lateral faces of the layers 16, 18, 20, 22, for example the lateral faces of the parts 18b, 20b, 22b and of the layer 16, and
- the part of the upper face of layer 15 uncovered by the layers 16, 18, 20, 22.

In the embodiment of Figure 4, layer 15 is biased with the same voltage as one of the electrodes, for example the source electrodes. For example, the layer 15 is biased at the ground. For example, both the layer 15 and the source electrode 42 is biased at the ground.

According to an embodiment, the lateral faces of the layers 16, 18, 20, 22 are separated from the electrode 42 by a dielectric layer, not represented. The electrode is then only in contact with the upper faces of layers 15 and 22.

An advantage of the described embodiments is that the threshold voltage of the transistor is higher, preferably positive. The transistor is therefore simpler to implement and more reliable.

Another advantage of the described embodiments is that the energy consumption of the transistor is lower, as a leakage current has been neutralized.

Another advantage of the described embodiments is that, as the leakage current generated by the two-dimensional electron gas 38 is stopped by the layer 15, the bottom of the cavity 26 can be above the layer 15 without increasing the leakage current.

Various embodiments and variants have been described. Those skilled in the art will understand that certain features of these embodiments can be combined and other variants will readily occur to those skilled in the art.

Finally, the practical implementation of the embodiments and variants described herein is within the capabilities of those skilled in the art based on the functional description provided hereinabove.

## Claims

1. A device comprising a transistor (10, 40), the transistor comprising:
- a p-doped semiconductor first layer (15);
- a piezoelectric semiconductor second layer (16), covering the first layer (15);
- a piezoelectric semiconductor third layer (18), covering the second layer (16);
- a piezoelectric semiconductor fourth layer (20), covering the third layer (18);
- a piezoelectric semiconductor fifth layer (22), covering the fourth layer (20), the transistor being configured to generate a first two-dimensional electron gas (36) between the fourth and fifth layers (20, 22); and
- a gate pattern (24) crossing going through the fifth (22) layer and at least part of the fourth layer (20).

2. The device according to claim 1, wherein the transistor (10, 40) is configured to generate a second two-dimensional electron gas (38) between the second (16) and third (18) layers, the first layer (15) being configured to suppress the second electron gas (38).

3. The device according to claim 1 or 2, wherein the gate pattern (24) crosses the third (18), fourth (20) and fifth (22) layers and at least part of the second layer (16).

4. The device according to any of claims 1 to 3, wherein the second (16) and fourth (20) layers are made of the same material.

5. The device according to any of claims 1 to 4, wherein the second (16) and fourth (20) layers are made of GaN.

6. The device according to any of claims 1 to 5, wherein the third (18) and fifth (22) layers are made of the same material.

7. The device according to any of claims 1 to 6, wherein the third (18) and fifth (22) layers are made of AlGaN, AsGa, AlN or InGaN.

8. The device according to any of claims 1 to 7, wherein the first layer (15) is made of GaN doped with magnesium, carbon or iron.

9. The device according to any of claims 1 to 8, wherein the first layer (15) is configured not to be biased.

10. The device according to any of claims 1 to 9, wherein the gate pattern (24) separates at least the fifth layer (22) in a first part (22a) and a second part (22b).

11. The device according to claim 10, wherein the gate pattern (24) separates the third (18), fourth (20) and fifth (22) layers in a first part (18a, 20a, 22a) and a second part (18b, 20b, 22b).

12. The device according to any of claims 1 to 10, wherein the device comprises a first electrode (32) in contact with the first part (22a) of fifth layer (22) and a second electrode (34, 42) in contact with the second part (22b) of fifth layer (22).

13. The device according to any of claims 1 to 11, wherein the first layer (15) is configured to be biased with the same voltage as either the first or second electrode (32, 34, 42) .

14. A method of using the device according to any of claims 1 to 13 in on-board chargers in electric vehicles, in charging stations, in photovoltaic systems, in home appliances, in telecommunication systems, in data centers and servers, in light emitting diode lighting systems or in equipment requiring power conversion.

15. A system comprising an on-board charger in electric vehicle, a charging station, a photovoltaic system, a home appliance, a telecommunication system, a data center, a server, a light emitting diode lighting system, or an equipment requiring power conversion, the system comprising the device according to any of claims 1 to 13.
